(19) Europäisches Patentamt
European Patent Office
Office européen des brevets

(11) **EP 2 095 136 B1**

(12) **EUROPEAN PATENT SPECIFICATION**

(45) Date of publication and mention
of the grant of the patent:
**30.04.2014 Bulletin 2014/18**

(21) Application number: **06817785.6**

(22) Date of filing: **22.12.2006**

(51) Int Cl.:
**G01R 15/24** (2006.01)

(86) International application number:
**PCT/CH2006/000735**

(87) International publication number:
**WO 2008/077256 (03.07.2008 Gazette 2008/27)**

(54) **Method for measuring high voltage and production of optical fiber used in said method**

Verfahren zur Hochspannungsmessung und Herstellungsverfahren für darin verwendbare optische Faser

Procédé de mesure des hautes tensions et procédé de fabrication d'une fibre utilisable pour le procédé de mesure

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**02.09.2009 Bulletin 2009/36**

(73) Proprietor: **ABB Research Ltd
8050 Zürich (CH)**

(72) Inventors:
• **BOHNERT, Klaus
CH-5452 Oberrohrdorf (CH)**
• **FRANK, Andreas
CH-8037 Zürich (CH)**
• **BRÄNDLE, Hubert
CH-8102 Oberengstringen (CH)**

(74) Representative: **Ingold, Mathias
ABB Patent Attorneys
c/o ABB Schweiz AG
Intellectual Property (SLE-I)
Brown Boveri Strasse 6
5400 Baden (CH)**

(56) References cited:
EP-A- 1 512 981     EP-A2- 0 682 261
EP-A2- 1 154 278     JP-A- S 575 003
JP-A- S5 786 802     JP-A- S63 141 004
JP-A- S63 151 867     US-A- 4 269 483
US-A- 4 477 723     US-A- 5 037 181
US-A- 5 049 175     US-A- 6 122 415
US-A1- 2004 160 608

• SHIM ET AL.: "Limunescence , radiation damage, and color center creation in Eu3+ - doped Bi4Ge3O12 fiber single crystals" APPLIED PHYSICS, [Online] vol. 93, no. 9, 2003, XP002446997 USA Retrieved from the Internet: URL:http://scitation.aip.org/getpdf/servle t/ GetPDFServlet?filetype=pdf&id=JAPIAU0000 93000009005131000001&idtype=cvips&prog=no r mal> [retrieved on 2007-08-16]
• WANG ET AL.: "Hybrid high refractive index polymer coatings" PROCEEDINGS OF SPIE, [Online] vol. 5724, no. 42, 2005, XP002446998 USA Retrieved from the Internet: URL:http: //www.brewerscience.com/fileadmin /bsi/home/ publication_list/2005/PhotWest20 05YWWeb2.pdf> [retrieved on 2007-08-16]

**Description**

Technical Field

The present invention relates to a method for measuring a voltage in the high voltage range, as well as to a method for manufacturing such a fiber.

In the context used herein, the term "high voltage" is used in the sense defined by IEC as any AC voltage exceeding 1 kV or any DC voltage exceeding 1.5 kV.

Related Art

It has been known to measure voltages using optical means.

A known technique for measuring high voltages is described in EP 0 682 261. It relies on the electro-optical effect, wherein an electrical field changes the refractive index or birefringence of a light-transmitting element, namely a bulk single crystal. The crystal is a Pockels-type electro-optical material that changes its refractive index or birefringence linearly with the applied electric field. The method described in EP 0 682 261 allows to measure the voltage over the crystal. For this purpose, two orthogonally polarized light beams are passed through the crystal twice, and the returned light beams are brought to interference, e.g. in a polarizer or an interferometer, for measuring their mutual phase shift.

Optical voltage sensors of this type for applications in air-insulated high-voltage substations commonly need expensive dielectric insulation. The sensor of EP 0 682 261 makes use of the electro-optical effect in a bulk $Bi_{12}Ge_4O_{12}$ (BGO) crystal. The voltage of a power line (up to several 100 kV) is applied to the crystal having a length typically between 100 mm and 250 mm. This results in very high electric field strengths near the crystal.

To avoid dielectric breakdown the crystal is mounted in a high-voltage insulator tube filled with $SF_6$ gas under pressure.

The voltage sensor described in Ref. [2] uses several small electro-optical crystals also mounted in a high-voltage insulator. The crystals measure the local electric fields. The sum of these local fields serves as an approximation of the line integral of the field. Here, the field strengths are lower and insulation with nitrogen at atmospheric pressure is sufficient. However, extra measures (permittivity-shielding) to stabilize the electric field distribution are necessary to avoid excessive approximation errors.

Document US 4,269,483 [17] discloses a device for electro-optically measuring a voltage in a high voltage conductor by using crystal fibers having a longitudinal, linear electro-optical effect and becoming birefringent in an electrical field.

Document JP-5786802 A [18] discloses an optical fiber which has optical rotary power and a switching function by making a core part of crystal of a Pb-Ge-O system having a specific atom ratio and by making a cladding part of crystal of a Pb-Ge-Si-O system of glass.

Document JP-63141004 A [19] discloses to manufacture a core clad type crystal fiber by pulling up a crystal fiber which has a core and a clad made of single crystal from fused liquid while applying a magnetic field to the fused part of the upper end part of a base material and suppressing the convection of the fused liquid.

Document JP-63151867 A [20] discloses an optical fiber electromagnetic field sensor comprising a fiber which has a core comprising a crystalline Pockels material and a core comprising a crystalline Faraday material arranged in a common clad.

Brief Description of the Invention

The problem to be solved by the present invention is to provide a method that improves the accuracy of such measurements.

This problem is solved by the method of claim 1 and claim 2. Accordingly, the light-transmitting element is a waveguiding fiber. The light is guided along said fiber between the points the voltage is to be measured over.

The fiber integrates the electric field along a continuous path, ideally over the full distance between ground and the high-voltage power line. As a result there is no particular enhancement in the field strength. The fiber can be packaged in a thin, inexpensive insulator tube or mounted inside other high voltage components such as a circuit breaker. Since the fiber measures the exact line integral of the field, variations in the field distribution, e.g. due to rain or surface pollution, do not cause any errors.

The disclosure also relates to a fiber for carrying out this method. Such a fiber is a waveguiding fiber and comprises an electro-optical material. The fiber should have a non-centric crystalline or molecular structure along its axis in order to exhibit a Pockels-type electro-optical effect under an axially applied electrical field.

Finally, the invention relates to a method according to claim 9 for manufacturing such a fiber where a material is molten, extruded through a nozzle and crystallized to a crystalline structure having a non-centric crystalline axis. This allows to manufacture a fiber showing the Pockels type electro-optical effect.

The invention can be used for measuring high voltages as defined above, and is particularly suited for measuring voltages exceeding 50 kV.

Brief Description of the Figures

Further embodiments, advantages and applications of the present invention are disclosed in the dependent claims as well as in the following detailed description, which makes reference to the annexed figures:

Fig. 1 shows a crucible and crystallizing apparatus for forming a crystalline fiber,
Fig. 2 shows a first measurement technique using such a fiber,
Fig. 3 shows a second measurement technique using such a fiber,
Fig. 4 shows a third measurement technique using such a fiber,
Fig. 5 shows a fourth measurement technique using such a fiber, and
Fig. 6 shows a comparative fifth comparative measurement technique using such a fiber.

Embodiments of the Invention

Some advantageous embodiments of the invention are described in the following.

1. Suitable material classes

For a line integration of the electric field the sensor must only measure the electric field component parallel to the integration path, i.e. only the electric field components parallel to the propagation path of the light should give rise to a measurable change of refractive index or birefringence. Field components perpendicular to the path do not contribute to the signal. Several electro-optical crystal classes meet this requirement. They have a non-centric crystalline or molecular structure along the fiber axis, i.e. along the direction of propagation of the light. They include materials free of intrinsic birefringence and materials with intrinsic birefringence. The corresponding crystal classes, the alignment of the crystal axes in a voltage sensor, the directions of the electro-optical axes as well as some examples for materials are listed in Ref. 1. A preferred material is $Bi_{12}Ge_4O_{12}$ (BGO).

Another fiber material can be a polymer having electro-optical, polar chromophores embedded therein, with the chromophores being preferentially aligned along the fiber axis (e.g. by applying an axial electrical field during the manufacturing process while the material is above its glass temperature for generating the required non-centric molecular structure).

2. The fiber

Advantageously, the fiber supports only a single spatial mode, which may have two orthogonal directions of polarization, wherein the birefringence between the orthogonal polarizations changes as a function of the axially applied electrical field. However, the fiber can also support more than one spatial mode.

The refractive index of the fiber is changed by the electrical field through the Pockels effect. Since in the Pockels effect the refractive index change depends substantially linearly on the applied electrical field, such materials allow accurate measurements over a wide field range. Furthermore, the Pockels effect is directionally selected since it only occurs for fields applied along non-centric crystal directions, which allows to adapt the fiber to ignore electric field components perpendicular to the path.

Advantageously, the fiber is placed in a controlled fluid environment, e.g. with the fluid being an oil. On the one hand, this allows to prevent the surface of the fiber from being contaminated, e.g. by dirt, thereby increasing its waveguiding properties and channel separation between the modes. Also, a fluid with a high refractive index close to the one of the fiber reduces the number of modes that can be guided within the fiber.

The fiber can also, for the same reason, be provided with a waveguiding core surrounded by a cladding. The core is crystalline of a crystal exhibiting the Pockels-type electro-optical effect, while the cladding can either be crystalline or non-crystalline. The core and the cladding are advantageously of the same carrier material but differ in dopants and/or structure, which reduces strain and increases cohesion. The cladding may also be a polymer.

Methods for manufacturing such fibers are described in the following.

3. Crystalline fiber manufacturing

Electro-optical materials like BGO can be grown in form of a light guiding fiber. A common growth method is the micro-pulling down technique [see Ref. 3, 4 for details]. The raw materials are heated and molten in a platinum crucible. The crucible has a micro nozzle at its bottom. A single crystal fiber is grown by bringing a small seed crystal to the nozzle and pulling it downward at constant speed. The orientation of the seed crystal determines the orientation of the crystal axes in the fiber. Fibers may be grown with lengths of at least 1 m to 2 m. Integration paths longer than the length of an individual fiber piece may be realized by arranging several fibers in series. So far such fibers have been of interest mainly as scintillating detectors for x-rays and gamma rays, e. g. in nuclear medicine, high energy physics or gamma ray spectroscopy.

*Rod-type crystal fiber*

In the simplest comparative case the fiber is a rod-type structure with a diameter in the range between e. g. 0.1 m to 4 mm, i.e. there is no fiber cladding and the fiber is highly multi-mode. The fiber may be operated as a (multi-mode) waveguide. The refractive index step between the fiber and the environmental medium creates the waveguide properties.

For voltage sensing the fiber may be placed in a controlled fluid environment, such as a gas atmosphere (e.g. nitrogen or $SF_6$ gas) or an oil-filled capillary consisting e.g. of fused silica. The refractive index of the oil should be below and ideally close to the index of the fiber material, as a small index difference reduces the number of guided modes. The refractive index of e. g. BGO at 800 nm is 2.07 [Ref. 5].

*Crystal fiber with polymer cladding*

An alternative is to apply a polymer cladding to the fiber, as it is known from so-called silica/hard polymer clad optical fibers. Here, the refractive index of the polymer is typically in the range between 1.4 and 1.5. A crystalline fiber requires a polymer with an enhanced refractive index, however. Polymers with high refractive indices are of particular interest for opto-electronics applications and have been developed for such purposes. By adding metal oxides such as titanium oxide or zirconium oxide, refractive indices in the visible as high as 1.9 were achieved [Ref. 6, 7]. Prototype materials with even higher refractive index have been re-ported. Another method to increase the refractive index of polymers including acrylates, epoxies and silicones is the addition of nano-particles of compound semiconductors such as ZnS particles [Ref. 8].

A voltage sensor is commonly operated in the near infrared. Therefore semiconductor particles with relatively small bandgaps (bandgaps near the red end of the visible spectrum, e.g. CdSe, CdTe) are of particular interest.

*Fiber with crystalline core and crystalline cladding*

A preferred solution is a fiber with a crystalline core and a crystalline cladding. A refractive index difference between the core and the cladding may be generated by adding appropriate dopants to the core and/or cladding. For example it is known that the addition of $Eu^{3+}$-dopants to BGO creates extra absorption bands [Ref. 4] and thus a change in the refractive index spectrum. Many other dopants for BGO have been reported (rare earth and metal ions including Ce, Nd, Sm, Tb, Ho, Er, Cr, Mn, Fe, Ni, Cu, W, Pb) [Ref. 9]).

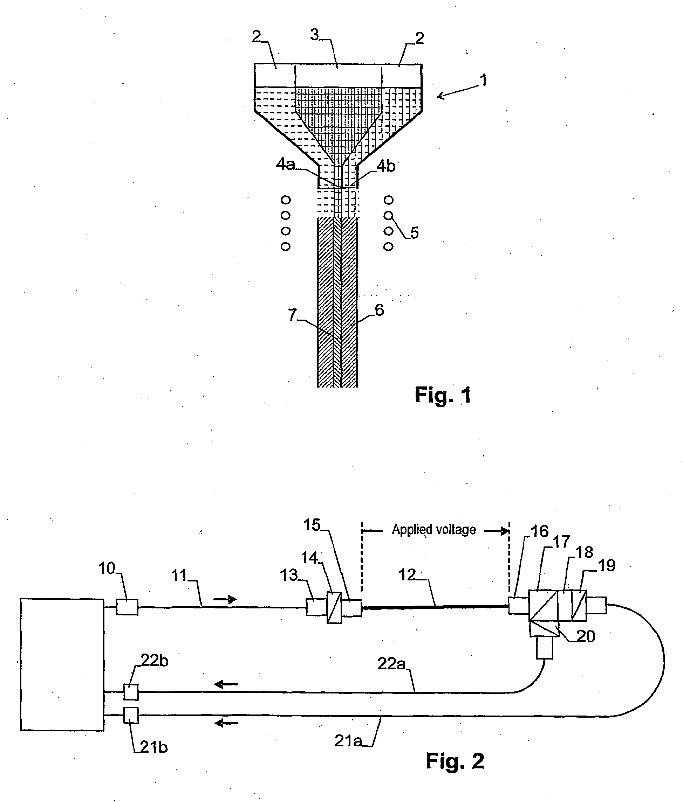

As shown in Fig. 1, a fiber with a core and a cladding may be grown by using a crucible 1 with two concentric compartments 2, 3 containing the raw materials with different concentrations and/or different types of dopants. Instead of a single nozzle there are two concentric micro-nozzles 4a, 4b at the bottom of two concentric crucible compartments 2, 3. The two materials from the concentric compartments 2, 3 are co-extruded (or co-pulled) and crystallized under control of a heater 5, such that the material from the outer compartment 2 forms the cladding 6 while the material from the inner compartment 3 forms the core 7.

*Crystal fiber with a waveguide through ion implantation*

A further comparative alternative to create a waveguide in an electro-optical fiber - or in bulk material - is by means of ion implantation. It has been reported that a waveguide in bulk BGO can be generated by implantation of $He^+$ ions [Ref. 10, 11]. The ion implantation produced an index increase of about 1%-2%. With this method, the fiber may serve as a "substrate" and a waveguiding core is created therein by irradiation with suitable ions.

*Crystal fiber with a laser-written waveguide*

Still another alternative to write a waveguide is irradiation with laser light, in particular short laser pulses. It is well-known that single-mode waveguides can be created in fused silica and other glasses by exposing the intended waveguide region with pico or femtosecond laser pulses [Ref. 12]. Light-induced refractive index changes can be created in electro-optical materials as well, particularly when appropriately doped. Persistent refractive index changes in undoped and chromium doped BGO were reported [Ref. 13]. Whence, by exposing the inner part of the material of the fiber to sufficiently strong laser pulses allows to form a waveguiding fiber core.

4. Polarimetric detection

Fig. 2 shows a set-up with a polarimetric detection scheme using an electro-optical sensing fiber as described above. Advantageously, a light source 10 of low coherence is used (for example a light emitting diode or a superluminescent diode (SLD)). In case of an SLD the light is preferably depolarized in a fiber depolarizer (not shown). An optical feed fiber 11 brings the light from the source 10 to the electro-optical sensing fiber 12. Depending on the type of light source 10 and the diameter of the electro-optical fiber 12, the feed fiber 11 may be multi-mode fiber, a single-mode fiber or a polarization maintaining single-mode fiber.

After collimation in a collimator 13 the light is polarized in polarizer 14 and coupled via a collimator 15 into the sensing fiber 12. The polarizer 14 is aligned at 45° to the electro-optical axes of the crystalline sensing fiber 12. The transmitted light exiting from the sensing fiber 12 is again collimated in a collimator 16 and then split in two channels by means of a beam splitter 17. In case of relatively thick sensing fibers the collimators 15 and 16 may be omitted (case with collimated beam in fiber). One of the two exit channels contains a quarter-wave plate ($\lambda$/4) 18 and a polarizer 19, the other channel only a polarizer 20. The wave plate axes of the quarter-wave plate 18 are aligned parallel to the electro-optical axes of the sensing fiber 12. The polarizers 19, 20 are aligned at 45° to the electro-optical axes of the sensing fiber 12. Two multimode fibers 21a, 22a bring the light back to two photo detectors 21b, 22b.

The quadrature signals in the two channels measured by the photodiodes 23, 24 are given by (see also Ref. 1) :

Channel 1 (with wave-plate 18):

$$I_1 = (1/2)\ I_0\ [1 + \cos\ (\Gamma - \pi/2)] \qquad (1)$$

$$I_1 = (1/2)\ I_0\ [1 - \sin \Gamma] \qquad (2)$$

Channel 2:

$$I_2 = (1/2)\ I_0\ [1 + \cos \Gamma] \qquad (3)$$

$I_0$ is proportional to the light intensity. For simplicity it is assumed that the fringe visibility is equal to unity. $\Gamma$ is the electro-optical phase retardation (Pockels effect) and varies with the applied voltage V according to:

$$\Gamma = \pi\ (V\ /\ V_\pi) \qquad (4)$$

Here $V_\pi$ is the so-called half wave voltage:

$$V_\pi = \lambda\ /\ (2\ r\ n^3) \qquad (5)$$

where $\lambda$ is the wavelength, r the relevant electro-optical coefficient for the longitudinal Pockels effect ($r_{63}$ (= $r_{41}$) in BGO) and n the refractive index of the electro-optical fiber. The half wave-voltage of BGO at 800 nm is about 41 kV [Ref. 5]. Since the applied voltage is typically up to several hundred kilovolts, the signals $I_1$ and $I_2$ go through several periods between two extreme values of the applied voltage. However, the two quadrature signals $I_1$, $I_2$ can be processed in such a way that the waveform of the applied voltage is reconstructed [Ref. 14].

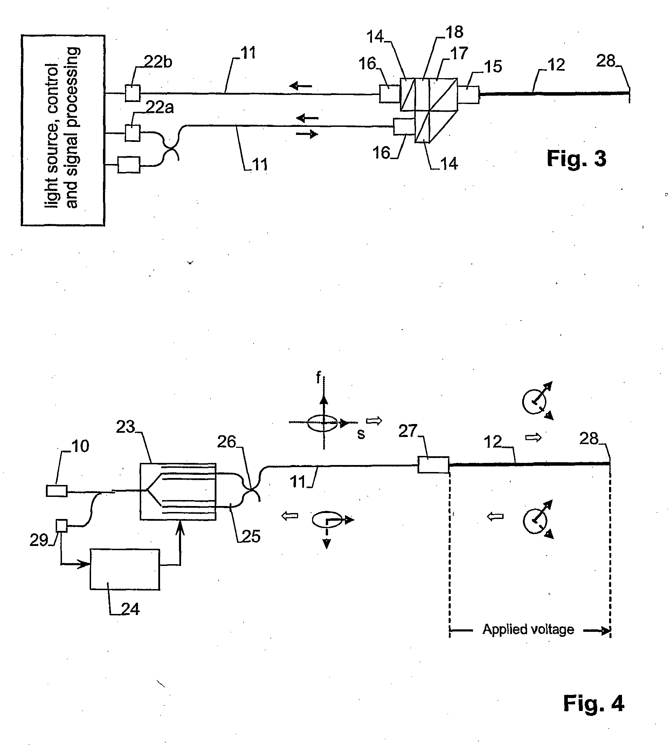

Fig. 3 shows a set-up where the fiber is operated in reflection using a mirror 28 at the end of sensing fiber 12. This arrangement of the optical components is equivalent to the one in Fig. 1b of Ref. 1. Compared to Fix.1 the sensitivity is doubled (the halve-wave voltage is lower by a factor of 2).

5. Interferometric detection

Fig. 4 shows a configuration employing a detection technique adapted from fiber-optic gyroscopes [Ref. 15] and interferometric current sensors, see EP 1 154 278. The detection of the large electro-optical phase shifts $\Gamma$ (up to several multiples of $\pi$) requires some adaptation of the signal processing not described in Ref 15 and EP 1 154 278, however.

The set-up of Fig. 4 comprises a polarizing beam splitter and phase modulator 23 that has two parallel polarized outputs, the relative phase of which can be changed by means of an applied electric voltage from a signal processor 24. One output is led directly, and the other via a 90° splice 25, to a polarization-maintaining fiber coupler 26. From there, the two orthogonally polarized waves are transmitted over a polarization maintaining feed fiber 11, to a 45° Faraday rotator 27, i.e. a non-reciprocal polarization rotator, from where they are coupled into sensing fiber 12. A mirror 28 at the end of sensing fiber 12 projects the waves back through sensing fiber 12, Faraday rotator 27 (where the beams are rotated by another 45°), feed fiber 11 and fiber coupler 26. The light waves pass through phase modulator 23 and are fed to a photo detector 29.

The non-reciprocal optical phase modulator 23 produces a periodic phase shift $\varphi_m = \Phi_m \sin \omega_m t$ with an amplitude $\Phi_m$ and an angular frequency $\omega_m = 2\pi\nu_m t$. The modulation frequency $\nu_m$ is preferably chosen as $\nu_m =. 1/(2T)$ (or, equivalently, $\omega_m = \pi/T$), where T is the roundtrip time of the light in the optical circuit, i.e. the time it takes the light exiting from modulator 23 to return thereto. The modulation amplitude $\Phi_m$ (for a given modulator drive voltage) is then at a maximum.

The detected signal is given by

$$I = I_o \ (1 + \cos \Delta\varphi) \qquad\qquad (6)$$

with

$$\Delta\varphi = \Phi_m + \Gamma \qquad (7)$$

Using Bessel functions the signal I can then be expressed as

$$\frac{I'}{I_o} = 1 + \left[ J_o(\Phi_m) + 2\sum_{k=1}^{\infty} J_{2k}(\Phi_m)\cos 2k\omega_m t \right]\cos\phi_s +$$
$$+ \left[ 2\sum_{k=1}^{\infty} J_{2k-1}(\Phi_m)\cos(2k-1)\omega_m t \right]\sin\phi_s \qquad\qquad (8)$$

with $\phi_S = \Gamma$.

If only the DC term and the 1st and 2nd harmonics (frequencies $\omega_m$, $2\omega_m$) are considered, the signal can be written as

$$I = I_o [ \ 1 + J_0(\Phi_m) + 2J_2(\omega_m) \cos(2\omega_m t) \cos \Gamma + \ldots$$
$$+ 2J_1(\Phi_m) \cos(\omega_m t) \sin \Gamma + \ldots \qquad (9)$$

For a given value of the modulation amplitude $\Phi_m$ the amplitudes of the 1st and 2nd harmonics vary in proportion to sin r and cos $\Gamma$, respectively, i.e. there are again two quadrature signals. The waveform of the applied voltage can be reconstructed from these two signals in the same way as it is done in the polarimetric scheme. Preferably, $\Phi_m$ is chosen such that the two harmonics have the same amplitude, i.e. $J_1(\Phi_m) = J_2(\Phi m)$. This is the case for $\Phi_m = 2.58$ rad. Another preferred value of $\Phi_m$ is 1.84 rad where $J_1(\Phi_m)$ is at its maximum. Alternatively, $\Phi_m$ may be chosen arbitrarily and the harmonics amplitudes may be properly normalized by the signal processor.

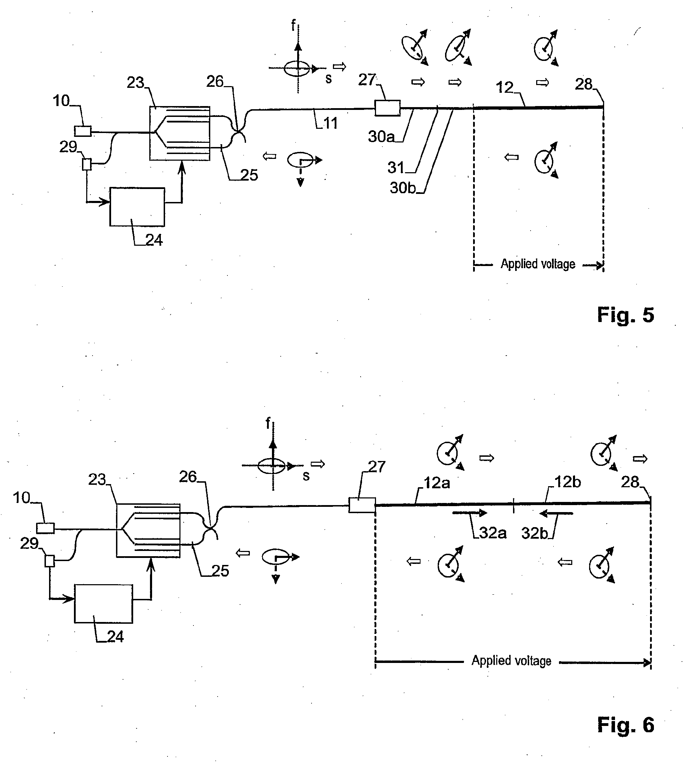

The configuration in Fig. 5 is the same as in Fig. 4 apart from the fact that the electro-optical sensing fiber 12 is separated from the Faraday rotator 27 by two sections of polarization-maintaining (pm) fiber 30a, 30b. The separation may be advantageous in the practical implementation of the sensor. The axes of the two pm fiber sections are at 45° with respect to axes of the pm feed fiber 11 before the rotator. There are two pm sections with a 90°-splice 31 in between in order to keep to total optical path imbalance at zero (see EP 1 154 278).

Fig. 6 shows a comparative set-up with two sections of electro-optical sensing fiber 12a, 12b. The electro-optical axes of the two sections 12a, 12b have a 90°angular offset and the directions 32a, 32b of the polar crystal axes in the fiber 12a, 12b are anti-parallel. This configuration is advantageous if fibers with intrinsic birefringence are used (crystal classes 6m2 and 2mm) as the intrinsic (i.e. field-independent) birefringent phase retardations in the two sections cancel each other. In contrast the electro-optical phase shifts add to each other.

As further alternatives the electro-optical fibers(s) could be part of a loop mirror configuration or a Sagnac configuration.

References

1. EP 0 682 261.
2. P. P. Chavez et al., IEEE Transactions on Power delivery 17, 362, 2002.
3. D. H. Yoon et al., J. Crystal Growth 142, 339, 1994.
4. J. B. Shim et al, J. Applied Physics 93, 5131, 2003.
5. P. A. Williams et al., Applied Optics 35, 3562, 1996.
6. Y. Wang et al., in Proceedings of SPIE, vol. 5724, 42, 2005.
7. T. Flaim et al., SPIE Proceedings on Optical Systems Design, Advances in Optical Thin Films, Vol. 5250, 423, 2003.
8. C. Lü et al., J. Matr. Chem., 13, 2189, 2003.
9. S. G. Raymond et al., Radiation Measurements 23, 195, 1994.
10. S. M. Mahdavi et al, J. of Physics D: Applied Physics 22, 1354, 1989.
11. S. M. Mahdavi et al, Nuclear Instruments and Methods in Physics Research B65, 251, 1992.
12. K. Miura et al., Appl. Physics Letters 71, 3329, 1997.
13. J. S. McCullough et al., Journal of Applied Physics 90, 6022, 2001.
14. US patent 4 904 931, Feb. 27, 1990.
15. "The fiber-optic gyroscope", Herve Lefevre, Artech House, Boston, London, 1993.
16. EP 1 154 278.
17. US 4,269,483
18. JP-5786802 A
19. JP-63141004 A
20. JP-63151867 A

List of Reference Numerals

1: crucible
2, 3: crucible compartments
4a, 4b: nozzles
5: heater
6: cladding
7: core
10: light source
11: feed fiber
12, 12a, 12b: sensing fiber
13: collimator
14: polarizer
15: collimator
16: collimator
17: beam splitter
18: quarter-wave plate
19: polarizer
20: polarizer
21a, 22a: multimode fibers
21b, 22b: photo detectors

23: beam splitter and phase modulator

24: signal processor

25: 90° splice

26: fiber coupler

27: Faraday rotator

28: mirror

29: photo detector

30a, 30b: polarization maintaining fiber

31: 90° splice

32a, 32b: directions of the polar crystal axes.

**Claims**

1. A method for measuring a voltage in the high voltage range, in particular a voltage exceeding 50 kV, between a first and a second point comprising the steps of

arranging at least one electro-optical light transmitting element between said first and said second point,

passing light through said electro-optical light transmitting element from said first to said second point, and measuring a phase shift introduced in said light by said electric field,

wherein said electro-optical light transmitting element forms a waveguiding fiber (12; 12a, 12b) and said light is guided in said fiber (12; 12a, 12b) between said first and said second point,

said phase shift is changed by said electric field through the Pockels effect,

said fiber (12; 12a, 12b) has a non-centric crystalline structure along a direction of propagation of said light, and only electric field components along the direction of the propagation path of the light give rise to a measurable change of refractive index or birefringence in said fiber (12; 12a, 12b) and field components perpendicular to the path do not contribute to the signal,

**characterised in that** said fiber (12; 12a, 12b) has a crystalline core (7), exhibiting said Pockets effect, surrounded by a cladding (6), wherein said cladding (6) is also crystalline and said cladding (6) and said core (7) consist of the same carrier material, but differ in dopants and/or structure, and

that the fiber material is $Bi_{12}Ge_4O_{12}$ (BGO) and $Eu^{3+}$-dopants or rare earth and metal ions including Ce, Nd, Sm, Tb, Ho, Er, Cr, Mn, Fe, Ni, Cu, W, Pb, are added to the core and/or the cladding.

2. A method for measuring a voltage in the high voltage range, in particular a voltage exceeding 50 kV, between a first and a second point comprising the steps of

arranging at least one electro-optical light transmitting element between said first and said second point,

passing light through said electro-optical light transmitting element from said first to said second point, and measuring a phase shift introduced in said light by said electric field,

wherein said electro-optical light transmitting element forms a waveguiding fiber (12; 12a, 12b) and said light is guided in said fiber (12; 12a, 12b) between said first and said second point,

said phase shift is changed by said electric field through the Pockels effect,

said fiber (12; 12a, 12b) has a non-centric crystalline structure along a direction of propagation of said light, and only electric field components along the direction of the propagation path of the light give rise to a measurable change of refractive index or birefringence in said fiber (12; 12a, 12b) and field components perpendicular to the path do not contribute to the signal,

**characterised in that** said fiber (12; 12a, 12b) has a crystalline core (7), exhibiting said Pockets effect, surrounded by a cladding (6), wherein said cladding (6) is a polymer, and

said cladding comprises polymers with increased refractive indices in the visible as high as 1.9 by adding metal oxides or with increased refractive index by adding nano-particles of compound semiconductors, in particular ZnS particles, and said core (7) comprises $Bi_{12}Ge_4O_{12}$.

3. The method of claim 2, wherein the metal oxide is titanium oxide or zirconium oxide.

4. The method of any of the preceding claims, wherein, for said light, said fiber (12; 12a, 12b) supports exactly one spatial mode with two orthogonal polarization directions, and wherein a birefringence between said polarization directions depends on said electric field.

5. The method of any one of the preceding claims, wherein the fiber (9) integrates the electric field along a continuous path over the full distance between ground and the high-voltage power line.

6. The method of claim 5, wherein the fiber is packaged in a thin, inexpensive insulator tube or mounted inside other high voltage components such as a circuit breaker.

7. The method of any of the preceding claims comprising the steps of
sending at least two polarizations of light on a roundtrip through said fiber (12; 12a, 12b),
using a modulator (23) for generating a periodic phase shift between the light in said polarizations at an angular frequency $\omega_m$,
measuring at least two signals derived from an interference of light from said two modes, a first signal measured at the frequency $\omega_m$ and a second signal measured at the angular frequency $2 \cdot \omega_m$.

8. The method of claim 7, wherein said angular frequency $\omega_m$ equals $\pi/T$, wherein T is a roundtrip time for light exiting from said modulator (23) and returning to said modulator (23).

9. A method for manufacturing a fiber suitable for a method for measuring voltage according to claim 1, comprising the steps of
melting a first material,
extruding said first material through a nozzle (4a, 4b),
crystallizing the extruded first material to a crystalline structure having a non-centric crystalline axis[original claim 12],
melting a second material,
co-extruding said first and said second material,
crystallizing said first and said second material such that said second material forms the cladding around said first material,
wherein the fiber with a core and a cladding is grown by using a crucible (1) with two concentric compartments (2, 3) containing the raw materials with different concentrations and/or different types of dopants, providing two concentric micro-nozzles (4a, 4b) at the bottom of the two concentric crucible compartments (2, 3), and
the two materials from the concentric compartments (2, 3) are co-extruded or co-pulled and crystallized under control of a heater (5), such that the material from the outer compartment (2) forms the cladding (6) while the material from the inner compartment (3) forms the core (7).

## Patentansprüche

1. Verfahren zur Messung einer Spannung im Hochspannungsbereich, insbesondere einer Spannung, die 50 kV überschreitet, zwischen einem ersten und einem zweiten Punkt, das die folgenden Schritte aufweist:

Anordnen von mindestens einem elektrooptischen lichtdurchlässigen Element zwischen dem ersten und dem zweiten Punkt,
Durchlassen von Licht durch das elektrooptische lichtdurchlässige Element von dem ersten zu dem zweiten Punkt, und
Messen einer Phasenverschiebung, die durch das elektrische Feld in das Licht eingeführt wird,
wobei das elektrooptische lichtdurchlässige Element eine Wellenleiterfaser (12; 12a, 12b) bildet und das Licht in der Faser (12; 12a, 12b) zwischen dem ersten und dem zweiten Punkt geleitet wird,
wobei die Phasenverschiebung durch das elektrische Feld durch den Pockels-Effekt geändert wird;
wobei die Faser (12; 12a, 12b) eine nicht zentrische Kristallstruktur entlang einer Ausbreitungsrichtung des Lichts aufweist, und
nur elektrische Feldkomponenten entlang der Richtung des Ausbreitungswegs des Lichts zu einer messbaren Änderung des Brechungsindex oder der Doppelbrechung in der Faser (12; 12a, 12b) führen und Feldkomponenten senkrecht zum Weg nicht zum Signal beitragen,
**dadurch gekennzeichnet, dass** die Faser (12; 12a, 12b) einen kristallinen Kern (7) aufweist, der den Pockels-Effekt aufweist und von einer Umhüllung (6) umgeben ist, wobei die Umhüllung (6) auch kristallin ist und die Umhüllung (6) und der Kern (7) aus demselben Trägermaterial bestehen, sich aber bei den Dotierstoffen und/oder der Struktur unterscheiden, und
dass das Fasermaterial $Bi_{12}Ge_4O_{12}$ (BGO) ist und $Eu^{3+}$-Dotierstoffe oder seltene Erden und Metallionen, die Ce, Nd, Sm, Tb, Ho, Er, Cr, Mn, Fe, Ni, Cu, W, Pb enthalten, zum Kern und/oder der Umhüllung hinzugefügt werden.

2. Verfahren zum Messen einer Spannung im Hochspannungsbereich, insbesondere einer Spannung, die 50 kV überschreitet, zwischen einem ersten Punkt und einem zweiten Punkt, das die folgenden Schritte umfasst:

Anordnen von mindestens einem elektrooptischen lichtdurchlässigen Element zwischen dem ersten und dem zweiten Punkt,

Durchlassen von Licht durch das elektrooptische lichtdurchlässige Element von dem ersten zu dem zweiten Punkt, und

Messen einer Phasenverschiebung, die durch das elektrische Feld in das Licht eingeführt wird,

wobei das elektrooptische lichtdurchlässige Element eine Wellenleiterfaser (12; 12a, 12b) bildet und das Licht in der Faser (12; 12a, 12b) zwischen dem ersten und dem zweiten Punkt geleitet wird,

wobei die Phasenverschiebung durch das elektrische Feld durch den Pockels-Effekt geändert wird,

wobei die Faser (12; 12a, 12b) eine nicht zentrische Kristallstruktur entlang einer Ausbreitungsrichtung des Lichts aufweist, und

nur elektrische Feldkomponenten entlang der Richtung des Ausbreitungswegs des Lichts zu einer messbaren Änderung des Brechungsindex oder der Doppelbrechung in der Faser (12; 12a, 12b) führen und Feldkomponenten senkrecht zum Weg nicht zum Signal beitragen,

**dadurch gekennzeichnet, dass** die Faser (12; 12a, 12b) einen kristallinen Kern (7) aufweist, der den Pockels-Effekt aufweist und von einer Umhüllung (6) umgeben ist, wobei die Umhüllung (6) ein Polymer ist, und

die Umhüllung Polymere mit erhöhten Brechungsindizes im sichtbaren Bereich, die so hoch wie 1.9 sind, durch Hinzufügen von Metalloxiden oder mit erhöhtem Brechungsindex durch Hinzufügen von Nanoteilchen von Verbindungshalbleitern, insbesondere ZnS-Teilchen aufweist, und der Kern (7) $Bi_{12}Ge_4O_{12}$ aufweist.

3. Verfahren nach Anspruch 2, wobei das Metalloxid Titanoxid oder Zirconiumoxid ist.

4. Verfahren nach einem der vorhergehenden Ansprüche, wobei für das Licht die Faser (12; 12a, 12b) genau eine Raummode mit zwei orthogonalen Polarisationsrichtungen unterstützt und wobei eine Doppelbrechung zwischen den Polarisationsrichtungen von dem elektrischen Feld abhängig ist.

5. Verfahren nach einem der vorhergehenden Ansprüche, wobei die Faser (9) das elektrische Feld entlang eines kontinuierlichen Wegs über den vollständigen Abstand zwischen der Erde und der Hochspannungsleitung integriert.

6. Verfahren nach Anspruch 5, wobei die Faser in einem dünnen, kostengünstigen Isolierrohr untergebracht ist oder in anderen Hochspannungsbauteilen, wie beispielsweise einem Leistungsschalter, angebracht ist.

7. Verfahren nach einem der vorhergehenden Ansprüche, das die folgenden Schritte umfasst:

Senden von mindestens zwei Polarisationen von Licht auf einen Umlauf durch die Faser (12; 12a, 12b),

Verwenden eines Modulators (23) zum Erzeugen einer periodischen Phasenverschiebung zwischen dem Licht in den Polarisationen bei einer Winkelfrequenz $\omega_m$,

Messen von mindestens zwei Signalen, die von einer Lichtinterferenz von den zwei Moden abgeleitet werden, einem ersten Signal, das bei der Frequenz $\overline{\omega}_m$ gemessen wird, und einem zweiten Signal, das bei der Winkelfrequenz $2 \cdot \overline{\omega}_m$ gemessen wird.

8. Verfahren nach Anspruch 7, wobei die Winkelfrequenz $\overline{\omega}_m$ gleich n/T ist, wo T eine Umlaufzeit für Licht ist, das aus dem Modulator (23) austritt und zu dem Modulator (23) zurückkehrt.

9. Verfahren zur Herstellung einer Faser, die sich für ein Spannungsmessungsverfahren nach Anspruch 1 eignet, das die folgenden Schritte aufweist:

Schmelzen eines ersten Materials,

Extrudieren des ersten Materials durch eine Düse (4a, 4b),

Kristallisieren des extrudierten ersten Materials in eine Kristallstruktur, die eine nicht zentrische Kristallachse aufweist [ursprünglicher Anspruch 12],

Schmelzen eines zweiten Materials,

Koextrudieren des ersten und des zweiten Materials,

Kristallisieren des ersten und des zweiten Materials, derart, dass das zweite Material die Umhüllung um das erste Material herum bildet,

wobei die Faser mit einem Kern und einer Umhüllung unter Verwendung eines Tiegels (1) mit zwei konzentrischen Kammern (2, 3) gezüchtet wird, die die Rohmaterialien mit unterschiedlichen Konzentrationen und/oder verschiedenen Typen von Dotierstoffen enthalten,

Bereitstellen von zwei konzentrischen Mikrodüsen (4a, 4b) am Boden der zwei konzentrischen Tiegelkammern (2, 3), und

Koextrudieren der zwei Materialien von den konzentrischen Kammern (2, 3) oder gemeinsames Ziehen und Kristallisieren unter der Steuerung eines Heizelements (5), derart, dass das Material von der äußeren Kammer (2) die Umhüllung (6) bildet, während das Material von der inneren Kammer (3) den Kern (7) bildet.

**Revendications**

1.  Procédé de mesure de tension dans une plage de haute tension, notamment une tension dépassant 50 kV, entre un premier et un second point, comprenant les étapes consistant à :

    - disposer au moins un élément de transmission de lumière électro-optique entre lesdits premier et second points ;
    - faire passer de la lumière à travers ledit élément de transmission de lumière électro-optique depuis ledit premier point vers ledit second point ; et
    - mesurer un décalage de phase introduit dans ladite lumière par ledit champ électrique ;
    - dans lequel ledit élément de transmission de lumière électro-optique forme une fibre de guidage d'onde (12 ; 12a, 12b) et ladite lumière est guidée dans ladite fibre (12 ; 12a, 12b) entre lesdits premier et second points ;
    - ledit décalage de phase est changé par ledit champ électrique par effet de Pockels ;
    - ladite fibre (12 ; 12a, 12b) possède une structure cristalline non centrique dans la direction de propagation de ladite lumière ; et
    - seules les composantes de champ électrique dans la direction du trajet de propagation de la lumière donnent lieu à un changement mesurable de l'indice de réfraction ou de la biréfringence dans ladite fibre (12 ; 12a, 12b) et les composantes de champ perpendiculaires au trajet ne contribuent pas au signal ;
    - **caractérisé en ce que** ladite fibre (12 ; 12a, 12b) possède une âme cristalline (7) ayant ledit effet de Pockels et est entourée d'un gainage (6), lequel gainage (6) est également cristallin et le gainage (6) et l'âme (7) sont faits du même matériau porteur mais diffèrent en termes de dopants et/ou de structure ; et
    - **en ce que** le matériau de la fibre optique consiste en du $Bi_{12}Ge_4O_{12}$ (BGO) et des dopants $Eu^{3+}$ ou des ions de terres et de métaux rares comprenant Ce, Nd, Sm, Tb, Ho, Er, Cr, Mn, Fe, Ni, Cu, W, Pb sont ajoutés à l'âme et/ou au gainage.

2.  Procédé de mesure de tension dans une plage de haute tension, notamment une tension dépassant 50 kV, entre un premier et un second point, comprenant les étapes consistant à :

    - disposer au moins un élément de transmission de lumière électro-optique entre lesdits premier et second points ;
    - faire passer de la lumière à travers ledit élément de transmission de lumière électro-optique depuis ledit premier point vers ledit second point ; et
    - mesurer un décalage de phase introduit dans ladite lumière par ledit champ électrique ;
    - dans lequel ledit élément de transmission de lumière électro-optique forme une fibre de guidage d'onde (12 ; 12a, 12b) et ladite lumière est guidée dans ladite fibre (12 ; 12a, 12b) entre lesdits premier et second points ;
    - ledit décalage de phase est changé par ledit champ électrique par effet de Pockels ;
    - ladite fibre (12 ; 12a, 12b) possède une structure cristalline non centrique dans la direction de propagation de ladite lumière ; et
    - seules les composantes de champ électrique dans la direction du trajet de propagation de la lumière donnent lieu à un changement mesurable de l'indice de réfraction ou de la biréfringence dans ladite fibre (12 ; 12a, 12b) et les composantes de champ perpendiculaires au trajet ne contribuent pas au signal ;
    - **caractérisé en ce que** ladite fibre (12 ; 12a, 12b) possède une âme cristalline (7) ayant ledit effet de Pockels et est entourée d'un gainage (6), dans lequel ledit gainage (6) est un polymère ; et
    - ledit gainage comprend des polymères ayant un indice de réfraction accru dans le domaine visible allant jusqu'à 1,9 par addition d'oxydes métalliques, ou un indice de réfraction accru par addition de nanoparticules de semi-conducteurs complexes, notamment des particules de ZnS, tandis que ladite âme (7) comprend du $Bi_{12}Ge_4O_{12}$.

3.  Procédé selon la revendication 2, dans lequel l'oxyde métallique est de l'oxyde de titane ou de l'oxyde de zirconium.

4.  Procédé selon l'une quelconque des revendications précédentes, dans lequel, pour ladite lumière, ladite fibre (12 ; 12a, 12b) supporte exactement un mode spatial avec deux directions de polarisation orthogonales, et dans lequel la biréfringence entre lesdites directions de polarisation dépend dudit champ électrique.

5. Procédé selon l'une quelconque des revendications précédentes, dans lequel la fibre (9) intègre le champ électrique le long d'un trajet continu sur toute la distance entre la terre et la ligne électrique haute tension.

6. Procédé selon la revendication 5, dans lequel la fibre est emballée dans un tube isolant fin et peu coûteux ou est montée dans d'autres composants de haute tension comme un coupe-circuit.

7. Procédé selon l'une quelconque des revendications précédentes, comprenant les étapes consistant à :

- envoyer au moins deux polarisations de lumière sur un aller-retour à travers ladite fibre (12 ; 12a, 12b) ;
- utiliser un modulateur (23) afin de générer un décalage de phase périodique entre la lumière dans lesdites polarisations à une fréquence angulaire $\omega_m$ ;
- mesurer au moins deux signaux dérivés d'une interférence de la lumière depuis lesdits deux modes, à savoir un premier signal mesuré à la fréquence $\omega_m$ et un second signal mesuré à la fréquence angulaire $2.\omega_m$.

8. Procédé selon la revendication 7, dans lequel ladite fréquence angulaire $\omega_m$ est égale à $\pi/T$, où T est un temps d'aller-retour pour la lumière sortant du modulateur (23) et retournant vers ledit modulateur (23).

9. Procédé de fabrication d'une fibre convenant à un procédé pour mesurer une tension selon la revendication 1, lequel comprend les étapes consistant à :

- fondre un premier matériau ;
- extruder ledit premier matériau à travers une buse (4a, 4b) ;
- cristalliser le premier matériau extrudé en une structure cristalline ayant un axe cristallin non centrique (originellement, revendication 12) ;
- fondre un second matériau ;
- co-extruder lesdits premier et second matériaux ;
- cristalliser lesdits premier et second matériaux de sorte que ledit second matériau forme le gainage autour du premier matériau ;
- dans lequel la fibre comprenant une âme et un gainage croît à l'aide d'un creuset (1) comprenant deux compartiments concentriques (2, 3) contenant des matières premières avec différentes concentrations et/ou différents types de dopants ;
- on utilise deux micro-buses concentriques (4a, 4b) au fond des deux compartiments de creuset concentriques (2, 3) ; et
- les deux matériaux des deux compartiments concentriques (2, 3) sont co-extrudés ou co-tirés et cristallisés sous le contrôle d'une unité de chauffage (5) de sorte que le matériau venant du compartiment externe (2) forme le gainage (6) tandis que le matériau venant du compartiment interne (3) forme l'âme (7).

**Fig. 1**

Applied voltage

**Fig. 2**

**Fig. 3**

Applied voltage

**Fig. 4**

**Fig. 5**

**Fig. 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0682261 A
- US 4269483 A
- JP 5786802 A
- JP 63141004 A
- JP 63151867 A
- EP 1154278 A
- US 4904931 A

### Non-patent literature cited in the description

- **P. P. CHAVEZ et al.** *IEEE Transactions on Power delivery,* 2002, vol. 17, 362
- **D. H. YOON et al.** *J. Crystal Growth,* 1994, vol. 142, 339
- **J. B. SHIM et al.** *J. Applied Physics,* 2003, vol. 93, 5131
- **P. A. WILLIAMS et al.** *Applied Optics,* 1996, vol. 35, 3562
- **Y. WANG et al.** *Proceedings of SPIE,* 2005, vol. 5724, 42
- **T. FLAIM et al.** SPIE Proceedings on Optical Systems Design. *Advances in Optical Thin Films,* 2003, vol. 5250, 423
- **C. LÜ et al.** *J. Matr. Chem.,* 2003, vol. 13, 2189
- **S. G. RAYMOND et al.** *Radiation Measurements,* 1994, vol. 23, 195
- **S. M. MAHDAVI et al.** *J. of Physics D: Applied Physics,* 1989, vol. 22, 1354
- **S. M. MAHDAVI et al.** *Nuclear Instruments and Methods in Physics Research,* 1992, vol. B65, 251
- **K. MIURA et al.** *Appl. Physics Letters,* 1997, vol. 71, 3329
- **J. S. MCCULLOUGH et al.** *Journal of Applied Physics,* 2001, vol. 90, 6022
- **HERVE LEFEVRE.** The fiber-optic gyroscope. Artech House, 1993